(19) Europäisches Patentamt
European Patent Office
Office européen des brevets

(11) **EP 3 462 195 B1**

(12) **EUROPÄISCHE PATENTSCHRIFT**

(45) Veröffentlichungstag und Bekanntmachung des Hinweises auf die Patenterteilung:
**02.11.2022 Patentblatt 2022/44**

(21) Anmeldenummer: **18197454.4**

(22) Anmeldetag: **28.09.2018**

(51) Internationale Patentklassifikation (IPC):
**G01R 31/11** $^{(2006.01)}$ **G01R 31/00** $^{(2006.01)}$
**H04B 3/493** $^{(2015.01)}$

(52) Gemeinsame Patentklassifikation (CPC):
**G01R 31/11; G01R 31/007; H04B 3/493**

(54) **PRÜFVORRICHTUNG UND PRÜFVERFAHREN ZUM PRÜFEN EINES DATENKABELS FÜR EIN KRAFTFAHRZEUG MITTELS KONSTANTSTROMQUELLE**

TEST DEVICE AND TEST METHOD FOR TESTING A DATA CABLE FOR A MOTOR VEHICLE USING CONSTANT CURRENT SOURCE

DISPOSITIF DE VÉRIFICATION ET PROCÉDÉ DE VÉRIFICATION DESTINÉS À VÉRIFIER UN CÂBLE DE DONNÉES POUR UN VÉHICULE AUTOMOBILE À L'AIDE D'UNE SOURCE DE COURANT CONSTANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.09.2017 DE 102017122684**

(43) Veröffentlichungstag der Anmeldung:
**03.04.2019 Patentblatt 2019/14**

(73) Patentinhaber: **Lisa Dräxlmaier GmbH
84137 Vilsbiburg (DE)**

(72) Erfinder:
• **Franke, Michael
84144 Geisenhausen (DE)**
• **Neumeier, Alexander
85368 Moosburg/Aich (DE)**

(56) Entgegenhaltungen:
**EP-A1- 2 664 932        US-A- 4 446 421
US-A1- 2002 130 668    US-A1- 2004 230 387**

**EP 3 462 195 B1**

## Beschreibung

### Technisches Gebiet

Die Erfindung betrifft eine Prüfvorrichtung zum Prüfen eines Datenkabels für ein Kraftfahrzeug. Ein solches Datenkabel kann beispielsweise für einen Datenbus oder ein Datennetzwerk des Kraftfahrzeugs vorgesehen sein. Mittels der Prüfvorrichtung kann erkannt werden, ob das Datenkabel eine Störstelle aufweist, die beispielsweise durch eine Unregelmäßigkeit der Geometrie des Datenkabels verursacht sein kann. Eine solche Störstelle würde im Betrieb des Kraftfahrzeugs die Übertragung von Daten stören. Die Erfindung umfasst auch ein Prüfverfahren, wie es mittels der erfindungsgemäßen Prüfvorrichtung durchgeführt werden kann.

### Stand der Technik

Ein Datenkabel kann in einem Kraftfahrzeug vorgesehen sein, um digitale Daten z.B. zwischen Steuergeräten zu übertragen. Es kann ein Bestandteil eines Datenbusses, z.B. eines CAN-Busses (CAN - Controller Area Network), oder eines Datennetzwerks, z.B. eines Ethernet-Netzwerks, sein. Zum Übertragen eines die Daten repräsentierenden Spannungssignals kann ein Datenkabel zwei elektrische Leitelemente aufweisen. In einer Ausgestaltung als Twisted-Pair-Kabel können als elektrische Leitelemente zwei verdrillte Drähte vorgesehen sein. In einer Ausgestaltung als Koaxialkabel können als elektrische Leitelemente ein Innenleiter, z. B. ein Draht, und ein darum koaxial angeordneter zylindrischer Außenleiter, z.B. aus einem Drahtgeflecht, vorgesehen sein.

Eine Prüfvorrichtung der eingangs genannten Art ist beispielsweise aus der deutschen Patentanmeldung DE 10 2017 108 954 bekannt. Die darin beschriebene Prüfvorrichtung sieht vor, ein zu prüfendes Datenkabel elektrisch aufzuladen und anschließend das geladene Datenkabel über einen Entladewiderstand wieder zu entladen. Ein sich am Entladewiderstand einstellender Verlauf eines Spannungssignals gibt Aufschluss über das Vorhandensein und die Lage einer möglichen Störstelle im Datenkabel.

Eine weitere Prüfvorrichtung ist in der deutschen Patentanmeldung DE 10 2017 108 955 beschrieben. Bei dieser Prüfvorrichtung ist vorgesehen, ein so genanntes Pulskabel elektrisch aufzuladen und anschließend das geladene Pulskabel mit dem zu prüfenden Datenkabel elektrisch zu verbinden, sodass sich das Pulskabel in das Datenkabel entlädt. An der elektrischen Verbindungsstelle zwischen Pulskabel und Datenkabel kann ein Verlauf eines elektrischen Spannungssignals abgegriffen werden, anhand welchem das Vorhandensein und die Lage einer möglichen Störstelle erkannt werden kann. Um ein Twisted-Pair-Kabel prüfen zu können, sieht die Prüfvorrichtung vor, dieses über einen sogenannten Balun (Balanced Unbalanced Transformator) mit der Prüfvorrichtung zu verschalten.

Die EP 2 664 932 A1 beschreibt eine Pulsgenerator-Schaltungsanordnung und ein Verfahren zur Erzeugung von Pulssignalen für die Isolationsfehlersuche in IT-Netzen. Eine Auswerte- und Steuerlogik ist in der Lage, den Isolationswiderstand eines angeschlossenen IT-Netzes während der Erzeugung eines Pulsstroms zu bestimmen.

Die US 2002/0130668 A1 beschreibt ein System zur Bestimmung von Lichtbogenfehlern, z.B. aufgrund einer defekten Isolation, zwischen mehreren elektrischen Leitern. An einem der Leiter wird eine Spannung angelegt, bis diese einen vorgegebenen Wert erreicht hat. Dabei werden aufgrund eines Lichtbogens reflektierte Signale hinsichtlich ihrer Ankunftszeiten ausgewertet, um die Stelle zu ermitteln, wo der Lichtbogen aufgetreten ist.

Die US 2004/0230387 A1 beschreibt ein Verfahren zur Klassifikation eines Teils eines elektrischen Signals, das durch einen elektrischen Leiter fließt. Das elektrische Signal wird digitalisiert und mit anderen gespeicherten digitalen Signalen verglichen, die mit verschiedenen Arten von Fehlern bei elektrischen Leitern korrespondieren.

### Beschreibung der Erfindung

Der Erfindung liegt die Aufgabe zugrunde, ein Datenkabel für ein Kraftfahrzeug auf eine mögliche Störstelle hin zu überprüfen.

Die Aufgabe wird durch die Gegenstände der unabhängigen Patentansprüche gelöst. Die Erfindung umfasst auch Ausführungsformen, die durch die abhängigen Patentansprüche, die folgende Beschreibung sowie die Figuren beschrieben sind.

Durch die Erfindung ist eine Prüfvorrichtung zum Prüfen eines Datenkabels für ein Kraftfahrzeug bereitgestellt. Die Prüfvorrichtung weist eine Konstantstromquelle auf, die dazu eingerichtet ist, eine Stromstärke eines elektrischen Stroms auf einen vorbestimmten Sollwert einzuregeln. Bei eingeregelter Stromstärke, wenn diese also den Sollwert aufweist, ist die Konstantstromquelle also insbesondere in der Lage, den Strom mit der eingeregelten Stromstärke aufrecht zu erhalten, selbst wenn ein elektrischer Widerstand, durch welchen der Strom fließt, verringert wird. Um ein Datenkabel mit der Prüfvorrichtung verbinden zu können, weist die Prüfvorrichtung des Weiteren eine Anschlusseinrichtung zum Anschließen eines Endes des zu prüfenden Datenkabels auf. Das Datenkabel kann also für die Prüfung mit einem Ende an die Anschlusseinrichtung angeschlossen oder mit dieser verbunden werden. Die Konstantstromquelle kann nun mittels eines Schaltvorgangs sprungartig mit der Anschlusseinrichtung und damit mit einem daran angeschlossenen Datenkabel verbunden werden. Hierzu ist eine Schalteinrichtung der Prüfvorrichtung dazu eingerichtet, die Konstantstromquelle in Abhängigkeit von einem Schaltsignal mit der Anschlusseinrichtung elektrisch zu verbinden. Ist an der Anschlusseinrichtung ein Datenkabel mit einem Ende angeschlossen, so wird also der Strom der Konstantstromquelle dann über die Schalteinrichtung und die Anschlusseinrichtung in das Datenkabel geleitet oder geführt. Indem dies mittels eines Schaltvorgangs geschieht, entsteht in dem Datenkabel ein Stromstoß, das heißt das Datenkabel wird von einer Stromwelle durchlaufen. An jedem Punkt des Datenkabels ergibt sich somit eine Sprungfunktion der Stromstärke. Mit dem Stromstoß geht ein Spannungsstoß einher. Weist das Datenkabel eine Störstelle auf, so ergibt sich eine Reflexion des Spannungsstoßes und an dem angeschlossenen Ende des Datenkabels und damit in der Anschlusseinrichtung ist diese Reflexion in einem Spannungssignal erkennbar. Entsprechend weist die Prüfvorrichtung auch einen Spannungsabgriff zum Erfassen des elektrischen Spannungssignals des Datenkabels auf. Um das Spannungssignal auszuwerten, weist die Prüfvorrichtung schließlich eine Steuereinrichtung auf, die dazu eingerichtet ist, die Konstantstromquelle mittels der Schalteinrichtung durch Erzeugen des entsprechenden Schaltsignals auf die Anschlusseinrichtung und damit auf ein Ende eines daran angeschlossenen Datenkabels aufzuschalten. Die Steuereinrichtung ist also dazu eingerichtet, mittels des Schaltsignals die Schalteinrichtung zu schalten und damit die Konstantstromquelle in der beschriebenen Weise mit der Anschlusseinrichtung zu verbinden. Die Steuereinrichtung ist des Weiteren dazu eingerichtet, anschließend, während also der auf den Sollwert eingeregelte Strom der Konstantstromquelle über die Anschlusseinrichtung in das Datenkabel hinein oder aus dem Datenkabel heraus fließt (je nach Stromrichtung des Stromes der Konstantstromquelle), an dem Spannungsabgriff das Spannungssignal zu erfassen.

Mit dem Schalten der Schalteinrichtung wird das Datenkabel von seinem Ende her mit einem Stromstoß beaufschlagt. Je nach örtlichem Verlauf der Impedanz des Datenkabels, also der Ortsfunktion des Impedanzbelags oder des Wellenwiderstands des Datenkabels, ergibt sich ein zeitlicher Verlauf des Spannungssignals am Spannungsabgriff. Eine Störstelle stellt eine lokale Veränderung des Impedanzbelags oder des Wellenwiderstands im Vergleich zum angrenzenden Bereich des Datenkabels dar. An einer solchen Störstelle ergibt sich bei konstantem Strom eine Veränderung der elektrischen Spannung im Datenkabel, die sich in dem Datenkabel als Reflexion hin zu dem angeschlossenen Ende ausbreitet, wo sie im Spannungssignal erkannt oder detektiert werden kann. Die Steuereinrichtung ist entsprechend dazu eingerichtet, zum Erkennen oder Detektieren einer Störstelle einen vorbestimmten Zeitabschnitt des Spannungssignals, also einen vorbestimmten zeitlichen Abschnitt oder Signalabschnitt, auf der Grundlage eines vorbestimmten Prüfkriteriums auf eine Störstelle in dem Datenkabel hin zu prüfen. Der überprüfte Zeitabschnitt ist derjenige Signalabschnitt des Spannungssignals, der sich während der Ausbreitung des Stromstoßes entlang des Datenkabels bis zu dessen anderem Ende einschließlich einer zusätzlichen Ausbreitungszeit des reflektierten Spannungssignals ergibt. Somit enthält dieser Zeitabschnitt die Information über den Impedanzverlauf des Datenkabels und damit über eine mögliche Störstelle in dem Datenkabel.

Durch die Erfindung ergibt sich der Vorteil, dass mittels einer Konstantstromquelle ein Datenkabel auf eine Störstelle hin überprüft werden kann. Damit ergibt sich eine einfach konstruierte Prüfvorrichtung, die auch in einem industriellen Umfeld zuverlässig funktionieren kann. Zudem ist das durch die Prüfvorrichtung realisierte Messverfahren oder Prüfverfahren ebenfalls robust gegen Störeinflüsse, sodass es sich ebenfalls für die industrielle Anwendung eignet, beispielsweise in einer Abschlussprüfung des Datenkabels nach dessen Herstellung oder vor und/oder nach dessen Montage in einem Kraftfahrzeug. Die Konstantstromquelle kann hierbei auf der Grundlage einer Stromquellenschaltung gemäß dem Stand der Technik realisiert sein. Beispielsweise kann sie auf der Grundlage eines integrierten Schaltkreises (IC - integrated circuit) realisiert werden. Ein solcher integrierter Schaltkreis für eine Stromquellenschaltung ist beispielsweise unter der Produktbezeichnung "LM317" von dem Unternehmen Texas Instruments ® erhältlich. Die Prüfvorrichtung lässt sich somit kostengünstig und bauraumsparend realisieren. Beispielsweise kann die Prüfvorrichtung als ein portables Handgerät ausgestaltet oder für einen Selbsttest in einem Kraftfahrzeug integriert sein.

Die Erfindung umfasst auch Ausführungsformen, durch die sich zusätzliche Vorteile ergeben.

Eine Ausführungsform sieht vor, dass das Prüfkriterium vorsieht, das Vorhandensein oder die Existenz einer Störstelle in dem Datenkabel zu signalisieren, falls der besagte Zeitabschnitt des Spannungssignals, der durch die Schalteinrichtung überprüft wird, zumindest zeitweise oder abschnittsweise außerhalb eines vorbestimmten Toleranzbands liegt. Dieses Prüfkriterium signalisiert also lediglich, ob überhaupt eine Störstelle vorliegt, ohne dass hierbei die Position oder Lage der Störstelle entlang des Datenkabels ermittelt werden muss. Hierzu kann ein Toleranzband definiert werden, also ein Werteintervall, das durch einen unteren Schwellenwert und einen oberen Schwellenwert definiert sein kann. Der Zeitabschnitt des Spannungssignals muss dann vollständig innerhalb des Toleranzbands oder Werteintervalls verlaufen, damit das Datenkabel als frei von Störstellen erkannt wird. Vorteil dieser Ausführungsform ist, dass kein genauer Signalverlauf analysiert oder definiert werden muss, um das Vorhandensein einer Störstelle zu erkennen. Insbesondere ist keine zeitliche Auflösung des Spannungssignals notwendig. Dieses Prüfkriterium lässt sich somit mit geringem Hardwareaufwand und Berechnungsaufwand realisieren.

Eine Ausführungsform sieht vor, dass das Prüfkriterium vorsieht, den Zeitabschnitt des Spannungssignals mit zumindest einem Schwellenwert zu vergleichen und bei Überschreiten oder Unterschreiten des jeweiligen Schwellenwerts das Vorhandensein der Störstelle zu signalisieren. Diese Ausführungsform lässt sich als analoge Schaltung auf der Grundlage zumindest eines Komparators realisieren. Der schaltungstechnische Aufwand ist somit gering. Mit dieser Ausführungsform kann z.B. die Überwachung des beschriebenen Toleranzbandes realisiert werden. Das Prüfkriterium kann auch vorsehen, dass eine Anzahl derjenigen Ereignisse, bei denen das Überschreiten oder Unterschreiten eines Schwellenwerts signalisiert wird, gezählt oder ermittelt wird. Mittels eines Zählers wird also gezählt, wie oft der Schwellenwert über- oder unterschritten wird. Es wird bei diesem Prüfkriterium nur dann eine Störstelle signalisiert, falls die ermittelte Anzahl größer als eine vorbestimmte Mindestanzahl ist. Dies weist den Vorteil auf, dass eine Störstelle auch bei einem solchen Datenkabel erkannt werden kann, bei welchen sich aufgrund seiner baulichen Beschaffenheit auch ohne eine Störstelle eine Überschreitung oder Unterschreitung eines Schwellenwerts ergibt. Dies kann beispielsweise der Fall sein, wenn eine Schelle das Datenkabel an einer Stelle umschließt und dort eine Änderung der lokalen Impedanz verursacht. Durch Ausblenden der Mindestanzahl an Über- oder Unterschreitungen können solche bekannten Eigenschaften des Datenkabels ausgeblendet werden.

Eine Ausführungsform sieht vor, dass das Prüfkriterium vorsieht, einen Zeitverlauf des Zeitabschnitts zu ermitteln. Mit anderen Worten wird der Zeitabschnitt auch zeitaufgelöst erfasst oder abgetastet. Beispielsweise kann hierzu mittels eines Analog-Digital-Wandlers und/oder eines Oszilloskops das Spannungssignal abgetastet werden. Das Prüfkriterium sieht dann des Weiteren vor, eine Position oder Lage der Störstelle entlang des Datenkabels mittels einer vorbestimmten Zuordnungsvorschrift zu ermitteln, welche jedem Zeitpunkt des Zeitverlaufs des Spannungssignals einen jeweiligen entsprechenden Ort entlang des Datenkabels zuordnet. Die Zuordnungsvorschrift kann beispielsweise auf der Grundlage einer Tabelle oder einer Formel realisiert sein. Die Lage der Störstelle kann beispielsweise als Abstand vom angeschlossenen Ende des Ladekabels beschrieben oder definiert sein. Hierzu kann derjenige Durchtrittszeitpunkt zugrunde gelegt werden, zu welchem erkannt wird, dass das Spannungssignal einen Schwellenwert überschreitet oder unterschreitet. Die Zuordnungsvorschrift kann auf der Grundlage der Signallaufzeit, die durch den Durchtrittszeitpunkt repräsentiert ist, sowie der bekannten Ausbreitungsgeschwindigkeit des Spannungssignals auf dem Datenkabel ermittelt werden. Mittels dieser Ausführungsform ist also eine ortsaufgelöste Prüfung des Datenkabels möglich, sodass eine Störstelle lokalisiert werden kann, also ihre Lage ermittelt werden kann. Mittels der Ausführungsform ist auch die Erkennung von mehr als einer Störstelle und/oder die Erkennung eines Anfangs und eines Endes einer Störstelle und damit ihrer Länge möglich.

Eine Ausführungsform sieht vor, dass das Prüfkriterium vorsieht, einen Deltawert oder Unterschiedswert einer Amplitudenänderung, welche der Zeitabschnitt des Spannungssignals aufweist, dazu zu verwenden, der Störstelle einen Wert einer Abmessung und/oder einer Beschaffenheit zuzuordnen. Der Deltawert beschreibt, wie groß eine Amplitudenänderung ist, also eine Änderung des Spannungssignals bezüglich angrenzender Signalabschnitte des Spannungssignals. Die Zuordnung von Deltawert zu Abmessungswert kann mit einer entsprechenden Zuordnungsvorschrift realisiert werden, die beispielsweise auf der Grundlage einer Tabelle oder Formel realisiert sein kann. Die Abmessung kann ein Durchmesser oder ein Ausmaß der Störstelle sein. Die Beschaffenheit kann sich z.B. auf die Änderung der Impedanz im Bereich der Störstelle beziehen. Diese Impedanzänderung ist es auch eigentlich, die die Amplitudenänderung bewirkt. Sie kann mit einer Abmessung der Störstelle korreliert sein, z.B. mit einem Abstand der beiden elektrischen Leitelemente des Datenkabels, sodass auf diesen Abstand rückgeschlossen werden kann. Mit dem ermittelten Wert wird also die Abmessung und/oder Beschaffenheit quantifiziert. Die Ausführungsform weist den Vorteil auf, dass ein Einfluss oder eine Auswirkung der Störstelle auf den Betrieb oder die Eignung des Datenkabels abgeschätzt oder bewertet werden kann.

Die Erfindung sieht zudem vor, dass das Prüfkriterium unabhängig von einer Verschaltung des anderen Endes des Datenkabels ist. Mit anderen Worten sieht das Prüfkriterium vor, dass nur ein solcher Zeitabschnitt des Spannungssignals berücksichtigt wird, der sich ergibt, bevor eine Reflexion eines Signals am anderen Ende des Datenkabels wieder das erste, angeschlossene Ende des Datenkabels oder den Spannungsabgriff erreicht. Der Zeitabschnitt ist also dahingehend zeitlich begrenzt, d.h. er endet früh genug, bevor diese Reflexion des anderen Endes mit berücksichtigt wird. Das Prüfkriterium bezieht sich auch nur auf denjenigen Zeitabschnitt des Spannungssignals, in welchem die jeweils erste Reflexion einer Störstelle am Spannungsabgriff eintreffen kann. Hierdurch ergibt sich der Vorteil, dass das Datenkabel nicht mit einer vorbestimmten Abschlussschaltung verschaltet werden muss, um das Prüfkriterium zu überprüfen. Das andere Ende des Datenkabels kann offen sein oder kurzgeschlossen sein oder mit einer anderen Impedanz verbunden sein. Hierbei kann der Kurzschluss oder die andere Impedanz bezüglich der beiden elektrischen Leitelemente des Datenkabels und/oder einem Bezugspotential, z.B. einem Massepotential, wirksam sein.

Eine Ausführungsform sieht vor, dass bei der Konstantstromquelle eine Zeitkonstante zum Einregeln der Stromstärke größer ist als eine Schaltdauer der Schalteinrichtung und als eine zeitliche Dauer des Zeitabschnitts. Die Zeitkonstante ist diejenige Zeitdauer, die bei Vorhandensein einer Regelabweichung (Unterschied eines Istwerts der Stromstärke des Stroms der Konstantstromquelle zu dem besagten Sollwert) benötigt wird, um die Stromstärke wieder auf den Sollwert soweit einzuregeln oder einzustellen, dass die Regelabweichung halbiert ist oder um den Faktor 1/e (e - Eulersche Konstante) abgeklungen oder verringert ist. Die Zeitkonstante ist bevorzugt mindestens um den Faktor 3 größer, bevorzugt um den Faktor 10. Mit anderen Worten ist die Konstantstromquelle aufgrund ihrer Zeitkonstante derart träge oder ihre Reaktion derart langsam, dass die Stromstärke des Stroms sich während der Schaltdauer und auch während des Zeitabschnitts unverändert bleibt oder die Änderung zumindest insignifikant ist. Hierdurch wirkt sich eine Veränderung der Impedanz entlang des Datenkabels aufgrund einer Störstelle ausschließlich auf das Spannungssignal aus und eben nicht auf die Stromstärke.

Beim Schalten der Schalteinrichtung wird davon ausgegangen, dass die Stromquelle die Stromstärke des Stromes bereits vollständig auf den Sollwert eingeregelt hat. Um dies zu erreichen, sieht eine Ausführungsform vor, dass ein ohmsches Widerstandselement bereitgestellt ist und die Schalteinrichtung zum Umschalten ausgelegt ist. Sie ist dazu eingerichtet ist, die Konstantstromquelle in Abhängigkeit von dem Schaltsignal abwechselnd mit dem Widerstandselement einerseits und der Anschlusseinrichtung für das Datenkabel andererseits elektrisch zu verbinden. Die besagte Steuereinrichtung ist dazu eingerichtet, mittels des Schaltsignals die Konstantstromquelle zunächst mit dem Widerstandselement zu verbinden und damit den Strom der Konstantstromquelle über das Widerstandselement zu führen, und zwar zumindest solange bis die Stromstärke den Sollwert aufweist. Hierzu kann beispielsweise eine Mindestzeitdauer vorgesehen sein oder abgewartet werden, während welcher die Konstantstromquelle mit dem Widerstandselement verbunden bleibt. Die Steuereinrichtung des Weiteren ist dazu eingerichtet, dann mittels des Schaltsignals die Schalteinrichtung umzuschalten. Damit wird also die Konstantstromquelle von dem Widerstandselement weggeschaltet. Sie wird auf die Anschlusseinrichtung umgeschaltet oder aufgeschaltet oder mit dieser verbunden. Damit prägt dann die Konstantstromquelle den auf den Sollwert eingeregelten Strom über die Anschlusseinrichtung in das Datenkabel ein. Das Widerstandselement weist einen vorbestimmten Referenzwiderstand auf. Das Widerstandselement kann hierbei als einzelnes diskretes Bauteil oder durch eine Schaltung mit mehreren Bauteilen oder durch eine elektrische Leitung mit einem vorgegebenen ohmschen Widerstandswert gebildet sein. Der ohmsche Widerstandswert des Widerstandselements kann in einem Bereich von 40 Ohm bis 200 Ohm liegen. Damit kann das Widerstandselement dem Wellenwiderstand des Datenkabels entsprechen.

Die besagte Anschlusseinrichtung zum Anschließen eines Endes des Datenkabels kann in einer Schaltung der Prüfvorrichtung ein Schaltungsabschnitt sein, der zwischen der Schalteinrichtung und dem Datenkabel bereitgestellt ist. Gemäß einer Ausführungsform weist die Anschlusseinrichtung ein Koaxial-Koppelelement zum Anschließen eines Datenkabels auf, das als Koaxialkabel ausgestaltet ist. Somit lässt sich also ein Koaxialkabel auf eine Störstelle hin überprüfen. Das Koaxial-Koppelelement kann in an sich aus dem Stand der Technik bekannter Weise ausgestaltet sein, beispielsweise mit einem Bajonett-Anschluss oder BNC-Anschluss (BNC - Bayonet Neill Boncelman).

Eine Ausführungsform sieht vor, dass das Koaxial-Koppelelement dazu ausgestaltet ist, bei angeschlossenem Koaxialkabel einen Außenleiter des Koaxialkabels mit einem Bezugspotential der Prüfvorrichtung zu koppeln. Hierdurch wirkt sich eine Spannungsveränderung aufgrund einer Störstelle ausschließlich auf das Spannungssignal des Innenleiters des Koaxialkabels aus, der mit dem Spannungsabgriff gekoppelt sein kann. Das Bezugspotential kann ein Massepotential der Prüfvorrichtung sein.

Eine Ausführungsform sieht vor, dass die Anschlusseinrichtung ein Twisted-Pair-Koppelelement zum Anschließen eines Datenkabels aufweist, das als Twisted-Pair-Kabel ausgestaltet ist. Ein solches Twisted-Pair-Kabel ist ein verseiltes oder verdrilltes Adernpaar aus zwei Drähten. Somit kann auch ein Twisted-Pair-Kabel mittels der Prüfvorrichtung geprüft werden. Insbesondere ist ein Twisted-Pair-Koppelelement für ein UTP-Kabel (UTP - unshieled twisted pair) vorgesehen. Das Koppelelement kann zum Anschließen eines platinenbasierten Zweileitersystems ausgestaltet sein. Ein platinenbasiertes Zweileitersystem kann z.B. Leiterbahnen einer Platine als Leitelemente für die Datenleitung vorsehen.

Eine Ausführungsform sieht hierbei vor, dass das Twisted-Pair-Koppelelement ein Balun aufweist (Balun - Balanced-Unbalanced Transformator). Hierdurch ist eine differenzielle Übertragung des Spannungssignals möglich.

Eine Ausführungsform sieht vor, dass die Steuereinrichtung einen Signalgenerator zum mehrfachen und/oder periodischen Schalten der Schalteinrichtung aufweist, und das Prüfkriterium eine vorbestimmte Mindestanzahl an erfolgreichen Prüfdurchläufen zum Erkennen der Störstelle vorsieht, bevor die Störstelle als erkannt signalisiert wird oder bevor anders herum ein Freigabesignal, das die Abwesenheit einer Störstelle signalisiert, erzeugt wird. Jeder Prüfdurchlauf sieht dabei jeweils das einmalige Aufschalten der Konstantstromquelle auf die Anschlusseinrichtung und das Zuführen des Stroms in das Datenkabel vor. Wird dieser Prüfdurchlauf mehrmals wiederholt, so kann beispielsweise ein Fehlalarm aufgrund einer Störung ausgeschlossen werden. Hierdurch wird die Prüfung des Datenkabels zuverlässiger. Die Mindestanzahl kann in einem Bereich von 1 bis 20 liegen.

Die Merkmale der beschriebenen Ausführungsformen können bei der Erfindung auch kombiniert werden.

Durch den Betrieb der erfindungsgemäßen Prüfvorrichtung ergibt sich ein erfindungsgemäß vorgesehenes Prüfverfahren zum Prüfen eines Datenkabels für ein Kraftfahrzeug. Eine Konstantstromquelle regelt hierbei also eine Stromstärke eines elektrischen Stroms auf einen vorbestimmten Sollwert und eine Schalteinrichtung verbindet die Konstantstromquelle in Abhängigkeit von einem Schaltsignal mit einer Anschlusseinrichtung, an welcher ein Ende des zu prüfenden Datenkabels angeschlossen ist. Mit "Verbinden" ist hierbei das elektrische Verbinden gemeint. Eine Steuereinrichtung schaltet entsprechend mittels des Schaltsignals die Schalteinrichtung, wodurch die Konstantstromquelle eben mit der Anschlusseinrichtung verbunden wird. Anschließend, während der bereits auf den Sollwert eingeregelte Strom der Konstantstromquelle über die Anschlusseinrichtung in das Datenkabel hinein oder aus dem Datenkabel hinaus fließt (abhängig von der Stromrichtung des Stromes), erfasst die Schalteinrichtung an einem Spannungsabgriff ein Spannungssignal des Datenkabels und überprüft einen vorbestimmten Zeitabschnitt des Spannungssignals auf der Grundlage eines vorbestimmten Prüfkriteriums, welches zum Erkennen einer Störstelle in der beschriebenen Weise ausgelegt oder ausgestaltet ist. Hierdurch wird das Datenkabel auf eine Störstelle hin geprüft. Zudem ist das Prüfkriterium unabhängig von einer Verschaltung eines anderen Endes des Datenkabels, wobei das Prüfkriterium vorsieht, dass nur ein solcher Zeitabschnitt des Spannungssignals berücksichtigt wird, der sich ergibt, bevor eine Reflexion eines Signals am anderen Ende des Datenkabels wieder das erste, angeschlossene Ende des Datenkabels oder den Spannungsabgriff erreicht.

Eine Ausführungsform sieht vor, dass nur bei unerfülltem Prüfkriterium, wenn keine Störstelle signalisiert wird, ein Freigabesignal zum Freigeben des Datenkabels für eine Montage und/oder einen Betrieb in dem Kraftfahrzeug erzeugt wird.

Zu der Erfindung gehören auch Ausführungsformen des erfindungsgemäßen Verfahrens, die Merkmale aufweisen, wie sie bereits im Zusammenhang mit den Ausführungsformen der erfindungsgemäßen Prüfvorrichtung beschrieben worden sind. Aus diesem Grund sind die entsprechenden Weiterbildungen des erfindungsgemäßen Verfahrens hier nicht noch einmal beschrieben.

## Kurze Figurenbeschreibung

Im Folgenden sind Ausführungsbeispiele der Erfindung beschrieben. Hierzu zeigt:

Fig. 1    eine schematische Darstellung einer ersten Ausführungsform der erfindungsgemäßen Prüfvorrichtung;

Fig. 2    eine schematische Darstellung einer zweiten Ausführungsform der erfindungsgemäßen Prüfvorrichtung;

Fig. 3    ein Flussschaudiagramm zu einer Ausführungsform des erfindungsgemäßen Verfahrens;

Fig. 4    ein Diagramm mit schematisierten Verläufen von Spannungssignalen für unterschiedliche Abschlusswiderstände eines in der Prüfvorrichtung geprüften Datenkabels;

Fig. 5    ein Diagramm mit schematisierten Verläufen von Spannungssignalen für ein homogenes und ein inhomogenes koaxiales Datenkabel;

Fig. 6    eine schematische Darstellung eines Datenkabels, das als Twisted-Pair-Kabel ausgestaltet ist;

Fig. 7    eine schematische Darstellung des Datenkabels von Fig. 6 mit einer Störstelle;

Fig. 8    ein Diagramm mit schematisierten Verläufen von Spannungssignalen für das Datenkabel von Fig. 7 mit unterschiedlich großen Störstellen; und

Fig. 9    ein Diagramm mit schematisierten Verläufen von Zeitsignalen einer relativen Abweichung der Spannungsverläufe von Fig. 8 bezüglich eines Spannungsverlaufs eines störfreien Datenkabels.

## Ausführungsbeispiel

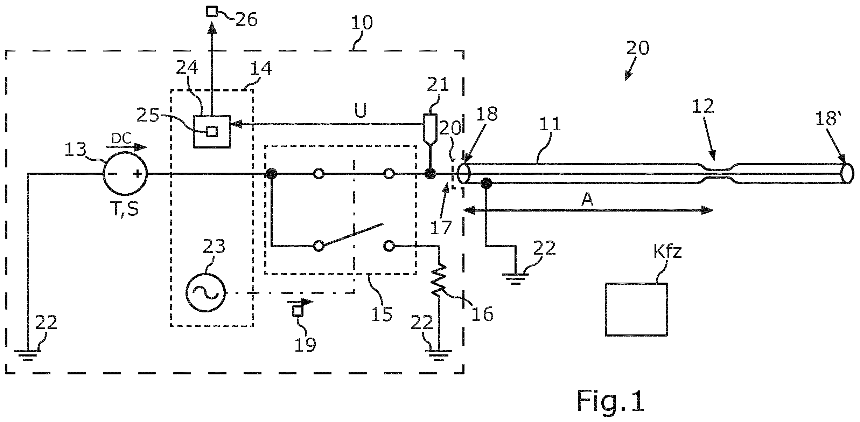

Fig. 1 zeigt eine Prüfvorrichtung 10, die dazu vorgesehen sein kann, ein Datenkabel 11 nach dessen Herstellung oder vor dessen Montage in einem Kraftfahrzeug Kfz oder bei in dem Kraftfahrzeug eingebauten Zustands daraufhin zu überprüfen, ob das Datenkabel 11 eine Störstelle 12 aufweist. Durch die Störstelle 12 kann ein Impedanzbelag oder Leitungsbelag, das heißt eine lokale Impedanz im Vergleich zum übrigen Datenkabel 11 verändert sein. Das Datenkabel 11 kann somit im Bereich der Störstelle 12 beispielsweise einen anderen Wellenwiderstand als im übrigen Datenkabel 11 aufweisen. Bei einer Datenübertragung von Daten über ein solches Datenkabel 11 mit Störstelle 12 kann es beispielsweise zu Reflexionen eines Datensignals kommen, wodurch eine Kommunikation beispielsweise zwischen Steuergeräten gestört oder beeinträchtigt sein kann. Mittels der Prüfvorrichtung 10 kann das Datenkabel 11 daraufhin überprüft werden, ob es eine solche Störstelle 12 aufweist.

Die Prüfvorrichtung 10 kann beispielsweise als ein portables Handgerät ausgestaltet sein, das von einem Benutzer getragen werden kann und an welches nacheinander mehrere, zu prüfende Datenkabel 11 angeschlossen werden können.

Die Prüfvorrichtung 10 kann eine Schaltung für eine Konstantstromquelle 13 aufweisen, die einen elektrischen Strom DC mit einer Zeitkonstante T auf einen Sollwert S einregeln kann, also einen Gleichstrom mit vorgebbarer Stromstärke bereitstellen kann. Der Sollwert S kann in einem Bereich von betragsmäßig bis zu 400 mA liegen. Des Weiteren kann die Prüfvorrichtung 10 eine Steuereinrichtung 14, eine Schalteinrichtung 15, ein Widerstandselement 16 und eine Anschlusseinrichtung 17 zum Anschließen eines Endes 18 des Datenkabels 11 aufweisen. In Fig. 1ist als Datenkabel 11 ein Koaxialkabel vorgesehen. Ein dem Ende 18 gegenüberliegendes, anderes Ende 18' muss für die Überprüfung nicht in besonderer Weise verschaltet sein. Das Ende 18' kann also ein offenes Ende (kein elektrischer Kontakt, kurzgeschlossen oder mit einem elektrischen Widerstand verbunden) sein. Die Prüfvorrichtung 10 kann auch in das Kraftfahrzeug Kfz integriert sein (nicht dargestellt), wodurch in dem Kraftfahrzeug Kfz ein Selbsttest bezüglich des eingebauten Datenkabels 11 durchgeführt werden kann.

Über die Schalteinrichtung 15 ist die Konstantstromquelle 13 sowohl mit der Anschlusseinrichtung 17 als auch mit dem Widerstandselement 16 verbunden. Die Schalteinrichtung 15 kann dazu eingerichtet sein, in Abhängigkeit von einem Schaltsignal 19 die Konstantstromquelle 13 zwischen dem Widerstandselement 16 und der Anschlusseinrichtung 17 umzuschalten oder abwechselnd zu verbinden. Die Schalteinrichtung 15 kann hierzu auf der Grundlage zumindest eines Transistors gebildet sein, beispielsweise mit einem Halbleiterschalter des Typs ADG918, wie er von dem Unternehmen Analog Devices Inc. ® erhältlich ist.

Die Anschlusseinrichtung 17 kann ein Koppelelement 20 zum Anschließen des Endes 18 des Datenkabels 11 sowie einen Spannungsabgriff 21 aufweisen. Mittels des Spannungsabgriffs 21 kann eine elektrische Spannung als ein Spannungssignal U abgegriffen werden, welches sich am Ende 18 des Datenkabels 11 ergibt. Das Spannungssignal U kann bezüglich eines Bezugspotentials 22, beispielsweise eines Massepotentials, definiert sein.

Die Steuereinrichtung 14 kann das Schaltsignal 19 für die Schalteinrichtung 15 beispielsweise mittels einer elektronischen Schaltung für einen Signalgenerator 23 erzeugen. Hierdurch kann die Schalteinrichtung 15 zyklisch oder periodisch oder wiederholt umgeschaltet werden. Die Steuereinrichtung 14 kann des Weiteren beispielsweise eine elektronische Auswerteschaltung 24 aufweisen, welche das Spannungssignal U des Spannungsabgriffs 21 empfangen kann. Die Auswerteschaltung 24 kann beispielsweise einen Komparator und/oder einen Analog-Digital-Wandler und/oder einen Mikroprozessor und/oder einen Mikrocontroller und/oder einen ASIC (Application Specific Integrated Circuit) aufweisen. Durch die Steuereinrichtung 14 kann das Spannungssignal U auf ein Prüfkriterium 25 hin oder gemäß einem Prüfkriterium 25 geprüft werden. Hierzu kann die Auswerteschaltung 24 vorgesehen sein. Die Steuereinrichtung 14 kann mittels der Analyseschaltung 24 ein Ergebnissignal oder Freigabesignal 26 erzeugen. Ist das Prüfkriterium 25 unerfüllt, so kann das Freigabesignal 26 signalisieren, dass das Datenkabel 11 frei von einer signifikanten Störstelle 12 ist. Ist das Prüfkriterium 25 erfüllt, so kann das Freigabesignal 26 blockiert oder unterdrückt werden oder ausbleiben, was signalisiert, dass das Datenkabel 11 eine Störstelle 12 aufweist. Es kann dann z. B. stattdessen eine Lage A der Störstelle 12 beispielsweise als Abstand zum Ende 18, und/oder ein Wert betreffend eine Abmessung und/oder eine Beschaffenheit der erkannten Störstelle 12 ausgegeben werden.

Der Spannungsabgriff 21 ist in Fig. 1 als ein Bestandteil der Anschlusseinrichtung 17 dargestellt. Mit anderen Worten ist der Spannungsabgriff 21 zwischen das Ende 18 des Datenkabels 11 oder das Koppelelement 20 einerseits und die Schalteinrichtung 15 andererseits geschaltet. Der Spannungsabgriff 21 kann aber auch an einer anderen Stelle vorgesehen sein, beispielsweise zwischen der Konstantstromquelle 13 und der Schalteinrichtung 15.

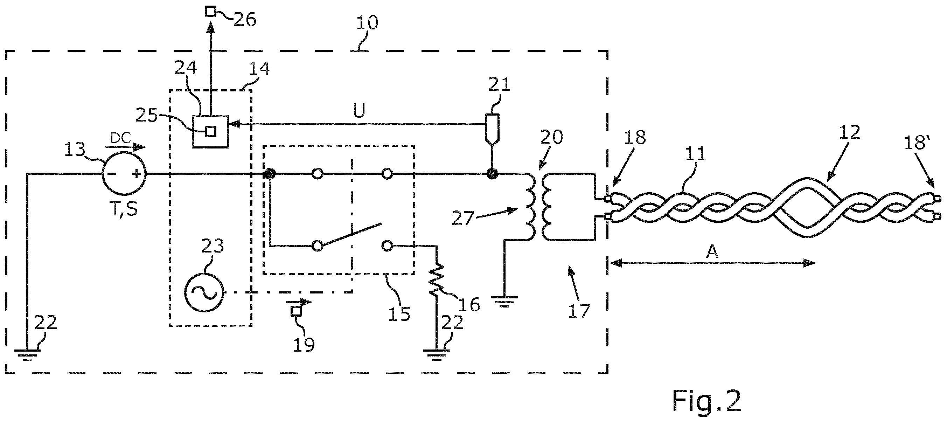

Fig. 2 veranschaulicht eine Ausführungsform der Prüfvorrichtung 10, die dazu eingerichtet ist, ein Datenkabel 11, das als Twisted-Pair-Kabel ausgestaltet ist, auf eine Störstelle 12 hin zu prüfen. Die Prüfvorrichtung 10 gemäß Fig. 2 kann bis auf die folgenden Unterschiede in derselben Weise ausgestaltet sein wie die Prüfvorrichtung 10 gemäß Fig. 1. Aus diesem Grund sind für funktionsgleiche Elemente dieselben Bezugszeichen vergeben. Für die Vermessung eines Twisted-Pair-Kabels oder eines UTP-Kabels gemäß Fig. 2 muss der Messaufbau angepasst werden, da eine differenzielle Übertragung notwendig ist. Der sonstige Aufbau der Prüfvorrichtung 10 ist identisch mit dem in Fig. 1 gezeigten, allerdings wird das als Twisted-Pair-Kabel ausgestaltete Datenkabel 11 an einen Balun (Balanced-Unbalanced Transformator) der Prüfvorrichtung 10 angeschlossen. Um das Datenkabel 11 als Twisted-Pair-Kabel prüfen zu können, kann also das Koppelelement 20 ein Balun 27 vorsehen oder aufweisen. Die Messung des zeitabhängigen Spannungssignals U und der Zusammenhang mit der ortsabhängigen Impedanz bleiben unverändert.

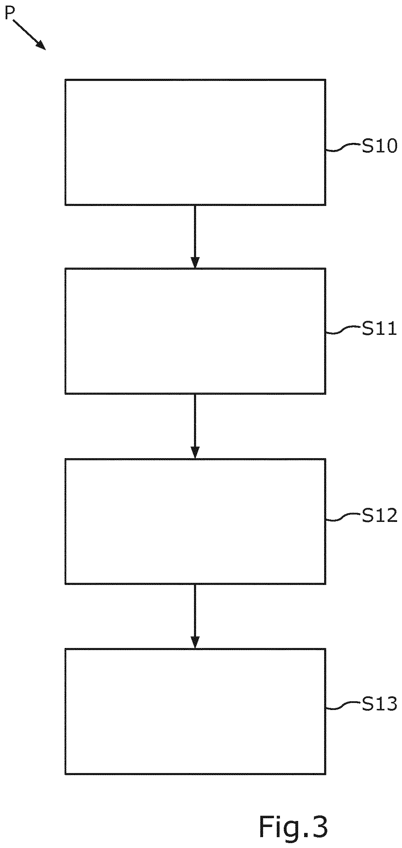

Fig. 3 veranschaulicht ein Prüfverfahren P, wie es durch die Prüfvorrichtung 10 gemäß Fig. 1 und Fig. 2 gleichermaßen durchgeführt werden kann. Für die Erläuterung des Prüfverfahrens P wird deshalb im Folgenden auch auf Fig. 1 und Fig. 2 Bezug genommen.

In einem Schritt S10 kann die Steuereinrichtung 24 durch Erzeugen eines entsprechenden Schaltsignals 19 die Schalteinrichtung 15 derart schalten, dass die elektrische Verbindung zwischen der Stromquelle 13 und dem Widerstandselement 16 bereitgestellt ist und somit die elektrische Verbindung zwischen der Konstantstromquelle 13 und der Anschlusseinrichtung 17 unterbrochen ist. Die Konstantstromquelle 13 kann dann die Stromstärke des Stroms DC auf den Sollwert S einregeln. Hierfür kann eine vorbestimmte Wartezeit oder Einregelzeit durch die Steuereinrichtung 14 vorgesehen werden.

In einem Schritt S11 kann dann die Steuereinrichtung 14 durch Erzeugen des entsprechenden Schaltsignals 19 die Schalteinrichtung 15 umschalten, sodass die Konstantstromquelle 13 durch die Schalteinrichtung 15 elektrisch mit der Anschlusseinrichtung 17 verbunden ist und elektrisch von dem Widerstandelement 16 entkoppelt ist. Der auf den Sollwert S eingeregelte Strom DC der Konstantstromquelle 13 fließt dann über die Schalteinrichtung 15 und die Anschlusseinrichtung 17 in ein elektrisches Leitelement des Datenkabels 11. Bei einem Koaxialkabel kann dies der Innenleiter sein. Bei einem Twisted-Pair-Kabel (Fig. 2) wird durch den Balun eine symmetrische Aufteilung erreicht.

In einem Schritt S12 kann mit dem Umschalten der Schalteinrichtung 15 durch die Steuereinrichtung 14 das Spannungssignal U am Spannungsabgriff 21 abgegriffen oder erfasst werden.

In einem Schritt S13 kann die Steuereinrichtung 14 einen vorbestimmten Zeitabschnitt des Spannungssignals U auf der Grundlage oder gemäß dem Prüfkriterium 25 überprüfen und in Abhängigkeit von einem Ergebnis der Überprüfung das Freigabesignal 26 in der beschriebenen Weise erzeugen.

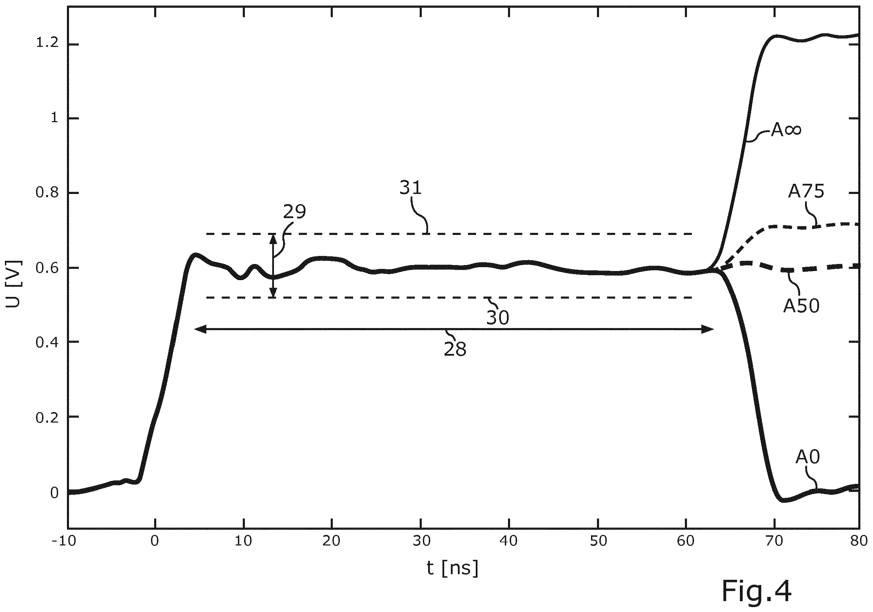

Fig. 4 veranschaulicht über der Zeit t beispielhafte Verläufe des Spannungssignals U für unterschiedliche am Ende 18' des Datenkabels 11 wirksame Abschlusswiderstände A0, A50, A75, A• . Die Zeit t ist in Nanosekunden angegeben, der Spannungsverlauf U in Volt. Dies gilt auch für die übrigen Diagramme. Die Abschlusswiderstände bedeuten hier:

A0: Kabelende 18' kurzgeschlossen
A50: Abschluss 50 Ohm
A75: Abschluss 75 Ohm
A• : Kabelende 18' offen.

Der Umschaltzeitpunkt lag für dieses Beispiel bei t=0s. Für das Prüfkriterium 25 kann ein vorbestimmter Zeitabschnitt 28 des Spannungssignals U zugrunde gelegt werden, welcher derjenigen Zeit entspricht, die der durch das Schalten der Schalteinrichtung 15 verursachte Stromstoß des Stroms DC benötigt, um erstmals von dem Ende 18 zum Ende 18' zu gelangen, zuzüglich der Zeit, die eine Reflexion eines Spannungssignals am Ende 18' bis hin zum Spannungsabgriff 21 benötigt. Bei bekannter Länge des Datenkabels 11 und bekannter Ausbreitungsgeschwindigkeit des Spannungssignals im Datenkabel 11 kann der Zeitabschnitt 28 somit festgelegt werden. Für den Zeitabschnitt 28 kann ein Toleranzband 29 vorgegeben sein, innerhalb welchem gemäß dem Prüfkriterium 25 der Zeitabschnitt 28 des Spannungssignals U verlaufen muss, damit das Freigabesignal 26 erzeugt wird. Es kann ein unterer Schwellenwert 30 und ein oberer Schwellenwert 31 vorgegeben werden, zwischen welchen der Zeitabschnitt 28 des Spannungssignals U verlaufen muss, damit das Freigabesignal 26 erzeugt wird. Durch die Steuereinrichtung 14 kann auch der zeitliche Verlauf des Zeitabschnitts 28 selbst beispielsweise durch Abtasten mittels eines Analog-Digital-Wandlers erfasst werden.

Im Folgenden ist eine Funktionsbeschreibung der Prüfvorrichtungen gemäß Fig. 1 und Fig. 2 angegeben. Es wird davon ausgegangen, dass ein zu prüfendes Datenkabel 11 als Prüfling an die jeweilige Prüfvorrichtung 10 angeschlossen ist. Der Prüfling ist deshalb im Folgenden wie das Datenkabel 11 mit dem Bezugszeichen 11 bezeichnet.

Für das in Fig. 4 dargestellte Diagramm wird der Funktionsgenerator 23 für die Steuerung verwendet. Die Konstantstromquelle 13 wird mit einem Wechselschalter der Schalteinrichtung 15 entweder auf einen Referenzwiderstand des Widerstandelements 16 oder den Prüfling 11 geschaltet. Die Regelzeit T der Konstantstromquelle 13 ist lang verglichen mit der Ausbreitungsgeschwindigkeit im Prüfling 11 oder der Schaltzeit der Schalteinrichtung 15. Bei Speisung des Referenzwiderstands des Widerstandelements 16 stellt sich ein konstanter Strom DC ein, der dann auf den Prüfling 11 geschaltet wird. Dadurch stellt sich am Messpunkt des Spannungsabgriffs 21 ein zeitabhängiges Spannungssignal U ein, welches durch den quasi konstanten Stromfluss abhängig ist von dem Wellenwiderstand entlang des Prüflings 11. Die Zeitabhängigkeit lässt sich über die Ausbreitungsgeschwindigkeit im Prüfling direkt in eine Ortsabhängigkeit mittels einer Zuordnungsfunktion umrechnen.

Die Demonstration des Messprinzips erfolgt in Fig. 4 anhand der Vermessung eines Koaxialkabels mit verschiedenen Abschlüssen am Ende 18'. Für den Einsatz im Feld, z.B. bei der Qualitätskontrolle von Datenkabeln 11 nach der Produktion lässt sich der Zustand des Kabelendes 18' nämlich oft nicht festlegen. In einem konkreten Beispiel liegen mehrere Datenkabel zusammen in einer elektrisch leitenden Wanne oder Rinne. Das Ende 18' kann somit bei Berühren der Wanne kurzgeschlossen und andernfalls ohne Abschlusswiderstand (offen) sein. Ein Messverfahren, welches nicht von den Randbedingungen abhängt, ist deshalb wichtig z.B. für einen solchen Anwendungen im Feldeinsatz.

Fig. 4 zeigt den Spannungsverlauf U bei Messung eines Koaxialkabels 11 für verschiedene Abschlüsse. Zugrunde gelegt ist ein 6 m langes Koaxialkabel 11, das mit der Prüfvorrichtung 10 gemäß Fig. 1 verbunden wurde. Das Spannungssignal U am Eingang dieses Prüflings wurde mit Hilfe eines Oszilloskops vermessen. Dabei wurden verschiedene Abschlüsse am Ende 18' des Prüflings 11 hergestellt (A• : offenes Ende, A75: 75 Ohm, A50: 50 Ohm und A0: kurzgeschlossen). Die einzelnen Messungen sind in Fig. 4 im Vergleich dargestellt, der Spannungsverlauf U bis zum Ende 18' des Datenkabels 11, d.h. im Zeitabschnitt 28 und damit das Prüfergebnis bleiben unverändert. Das Prüfkriterium 25 kann unabhängig vom Abschluss am Ende 18' ausgelegt werden.

Zur Umrechnung des Spannungsverlaufs U als Funktion der Zeit t in eine elektrische Länge als Funktion der Orts x muss die Ausbreitungsgeschwindigkeit von Signalen auf dem Kabel berücksichtigt werden (typischerweise 0,7 * Lichtgeschwindigkeit c0). Der Verkürzungsfaktor vr (also hier z.B. 0,7) ist abhängig von der Dielektrizitätskonstante des Materials zwischen den beiden Leitelementen des Datenkabels 11. Zusätzlich ist der Faktor 2 durch die Reflexionsmessung zu beachten. Es kann somit folgende Zuordnungsvorschrift vorgesehen sein:

$$x = (vr \cdot c0 \cdot t) / 2$$

wobei t die Laufzeit im Datenkabel 11 seit dem Umschalten der Schalteinrichtung 15 oder seit Beginn des Zeitabschnitts 28 ist.

Ergibt sich für ein Zeitpunkt t0 z.B. eine Veränderung der Amplitude des Spannungssignals U aufgrund einer Störstelle 12 (siehe Fig. 1), so kann die Lage A der Störstelle 12 berechnet werden zu A = (vr · c0 · t0) / 2.

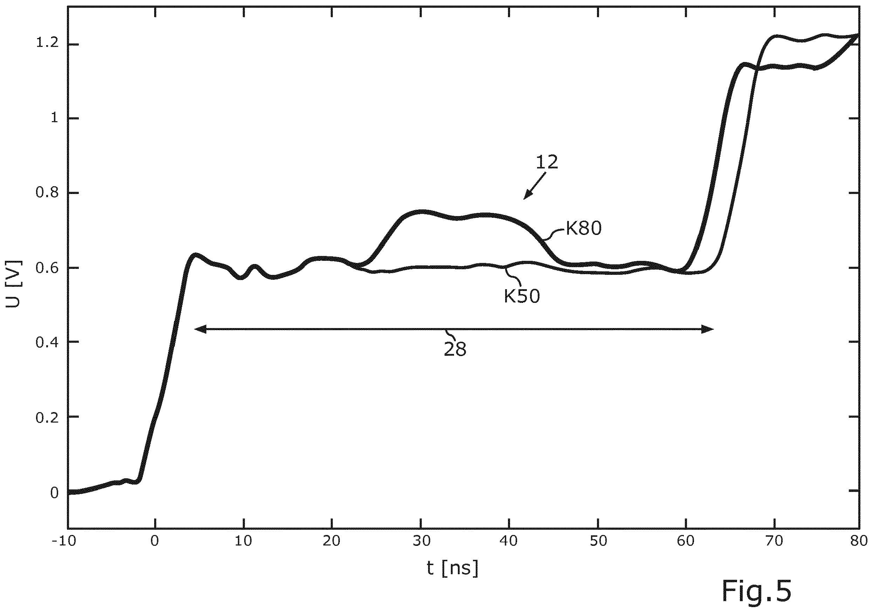

Fig. 5 zeigt eine Demonstration dieses Messprinzips anhand der Vermessung eines Datenkabels 11, das aus drei hintereinander verbundenen Koaxialkabeln mit wechselnder Impedanz gebildet wurde. Die Koaxialkabel wiesen die folgende Kombination aus Länge und Wellenwiderstand auf: 2 m mit 50 Ohm, 2 m mit 80 Ohm und 2 m mit 50 Ohm) durchgeführt. Das mittlere Koaxialkabel mit 80 Ohm Wellenwiderstand simuliert dabei eine Störstelle. Der Kabelverbund des Datenkabels 11 wurde wie in Fig. 1 dargestellt angeschlossen und das Spannungssignal U wiederum mit Hilfe eines Oszilloskops vermessen.

Das gemessene Spannungssignal U ist in Fig. 5 aufgetragen (Graph K80). Ein erhöhter Wellenwiderstand im Datenkabel 11 hat ein größeres Verhältnis zwischen Spannungssignal U und Strom DC der sich nach dem Umschalten im Datenkabel 11 ausbreitenden Welle zur Folge. Durch den quasi konstanten Stromfluss drückt sich dies direkt in einer erhöhten Spannung im Spannungssignal U aus. Im Vergleich ist ein 50 Ohm Kabel mit gleicher mechanischer Länge aufgetragen (Graph K50, siehe Fig. 5, dort ist eine veränderte elektrische Länge sichtbar).

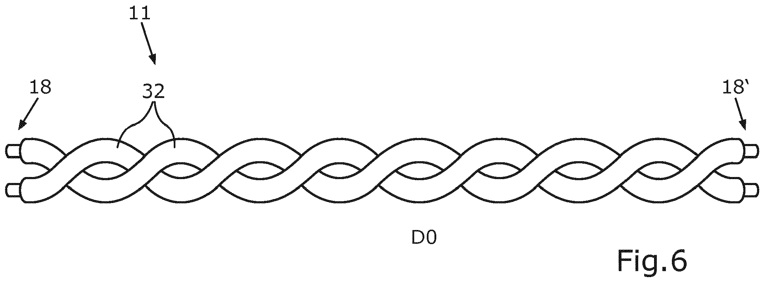

Fig. 6, Fig. 7 und Fig. 8 demonstrieren das Messprinzip anhand der Vermessung eines UTP-Kabels als Beispiel für ein Twisted-Pair-Kabel.

Fig. 6 zeigt ein Datenkabel 11 in einer Ausführung als Twisted-Pair-Kabels (hier als UTP-Kabel) mit zwei verdrillten Leitelementen 32, die hier jeweils als Draht ausgestaltet sind. Das Datenkabel 11 gemäß Fig. 6 weist keine Störstelle auf. Dieser Zustand ist im Folgenden als D0 bezeichnet.

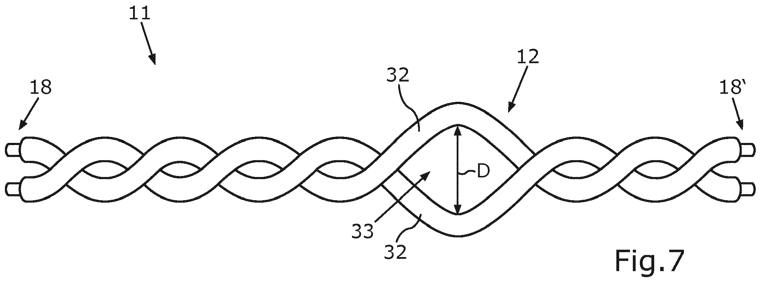

Fig. 7 zeigt das Datenkabel 11 von Fig. 6, bei welchem nun eine Störstelle 12 eingebracht wurde, indem die beiden Leitelemente 32 entdrillt wurden, sodass eine Schlaufe oder ein Auge 33 zwischen den Drähten 32 gebildet ist. Ein Durchmesser des Auges 33 beschreibt eine Abmessung D der Störstelle 12. Im Folgenden ist davon ausgegangen, dass die folgenden verschiedenen Abmessungen D1, D2, D3, D4, D5 für die Schlaufe oder das Auge 33 der Störstelle 12 zugrunde gelegt werden:

D1: Augenöffnung 10 Millimeter
D2: Augenöffnung 20 Millimeter
D3: Augenöffnung 30 Millimeter
D4: Augenöffnung 40 Millimeter
D5: Augenöffnung 50 Millimeter

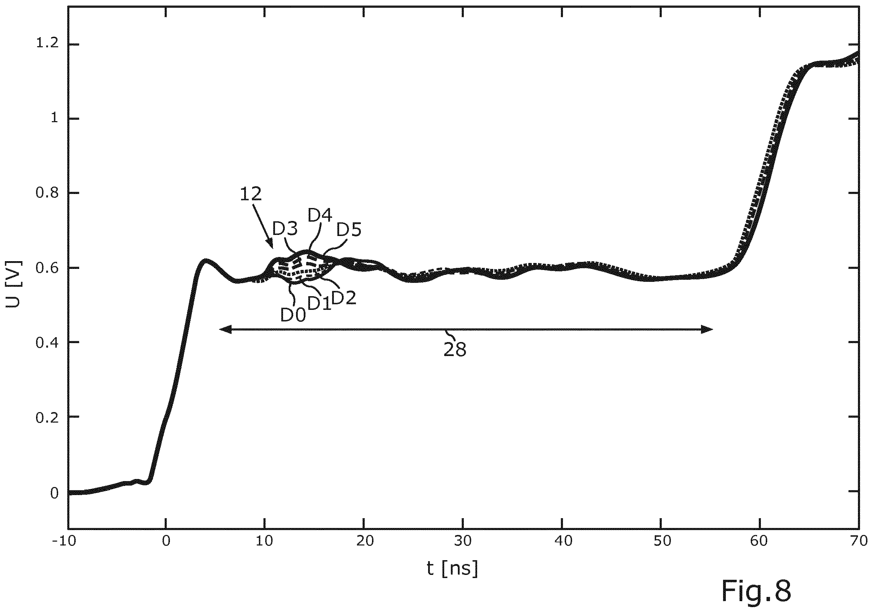

Zur Demonstration der Funktionsfähigkeit bei Vermessung eines UTP-Kabels, wurde ein UTP-Kabel ausgewählt und schrittweise entdrillt, d.h. die Augenöffnung oder Lasche wurde in 10 mm Schritten verändert (siehe Fig. 6 und Fig. 7). Der Messaufbau entspricht demjenigen von Fig. 2. Das Spannungssignal U (Fig. 8) wurde mit einem Oszilloskop aufgenommen. Angegeben sind die unterschiedlichen Fälle D1 bis D5 der Abmessung D der Augenöffnung nach Entdrillung und der nicht-entdrillte Fall D0. Die geringe Flankensteilheit und die damit verbundene Zeit- bzw. Ortsauflösung ist dem Aufbau im Labor geschuldet. Durch impedanzrichtige Leiterbahnen auf einer Platine und eine Auswahl geeigneter Bauteile ist eine deutliche Verbesserung möglich. Dennoch ist in Fig. 8 die schrittweise Entdrillung und die somit erhöhte Impedanz an dieser Störstelle 12 zu erkennen.

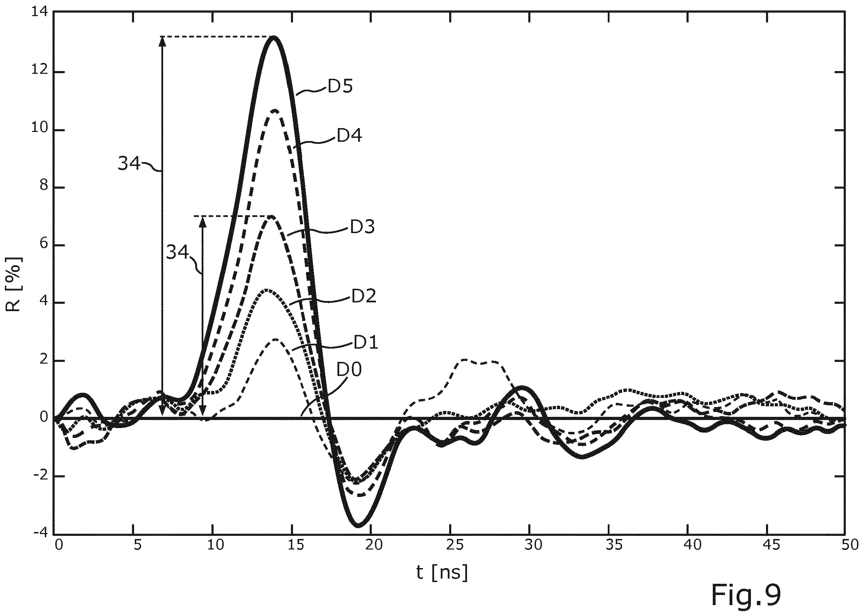

Fig. 9 zeigt ein Diagramm, um die relative Änderung R im Spannungssignal U darzustellen. Es ist die relative Änderung R zum nicht entdrillten Kabel (D0) aufgetragen. Dargestellt ist das gemessene Spannungssignal U für ein UTP-Kabel mit unterschiedlicher Entdrillung relativ zum Spannungsverlauf des unversehrten Datenkabels 11 (Fall D0). Angegeben ist die jeweilige Abmessung D1 bis D5 der Augenöffnung nach Entdrillung. Die jeweilige Amplitudenänderung 34 ist ein Maß für die Abmessung D der Störstelle 12 (hier beispielhaft veranschaulicht für D3 und D5).

Bei der Prüfvorrichtung 10 ist somit ein einfaches und robustes Messverfahren für die ortsaufgelöste Impedanz von Koaxial- und UTP-Leitungen oder -Kabeln dargestellt. Eine Konstantstromquelle 13 wird für die Messung verwendet. Der konstante Strom DC wird wechselweise über eine Schalteinrichtung 15 mit einem Entladewiderstand (Widerstandselement 16) und dem Prüfling verbunden. Das Spannungssignal U direkt nach der Umschaltung auf den Prüfling enthält Informationen über den örtlichen Impedanzverlauf des Prüflings.

Die Prüfvorrichtung 10 bietet somit ein einfaches und robustes Messverfahren für die ortsaufgelöste Impedanz von Koaxial- und UTP Leitungen. Eine Konstantstromquelle wird für die Messung verwendet. Der konstante Strom DC wird wechselweise über eine Schalteinrichtung 15 mit einem Referenzwiderstand und dem Prüfling verbunden. Das Spannungssignal U direkt nach der Umschaltung auf den Prüfling 11 enthält Informationen über den örtlichen Impedanzverlauf entlang des Prüflings 11.

Der Vorteil der Prüfvorrichtung 10 ist, dass keine Bedingungen an das andere Kabelende 18' gestellt werden (offen, kurzgeschlossen, beliebiger Abschlusswiderstand möglich). Das Spannungssignal U wird durch direktes Aufladen des Prüflings 11 erzeugt.

Die Simplizität kombiniert mit der Robustheit des Prüfverfahrens P stellt einen Vorteil für eine industrielle Anwendung zur Integration in eine EOL-Prüfanlage (EOL - End of Line) dar.

Die Prüfvorrichtung 10 ist als eigenes, z.B. portables Prüfgerät z.B. für die EOL-Prüfung oder in einem Kraftfahrzeug z.B. für einen Selbsttest des Kraftfahrzeugs Kfz bereitstellbar.

Die Ausführungsbeispiele zeigen somit eine ortsaufgelöste Impedanzmessung auf der Grundlage einer Konstantstromquelle.

BEZUGSZEICHENLISTE

| | |
|---|---|
| 10 | Prüfvorrichtung |
| 11 | Datenkabel |
| 12 | Störstelle |
| 13 | Konstantstromquelle |
| 14 | Steuereinrichtung |
| 15 | Schalteinrichtung |
| 16 | Widerstandselement |
| 17 | Anschlusseinrichtung |
| 18 | Ende des Datenkabels |
| 18' | Anderes Ende des Datenkabels |
| 19 | Schaltsignal |
| 20 | Koppelelement |
| 21 | Spannungsabgriff |
| 22 | Bezugspotential |
| 23 | Signalgenerator |
| 24 | Analyseschaltung |
| 25 | Prüfungskriterium |
| 26 | Freigabesignal |
| 27 | Balun |
| 28 | Zeitabschnitt des Spannungssignals |
| 29 | Toleranzband |
| 30 | Unterer Grenzwert |
| 31 | Oberer Grenzwert |
| 32 | Draht |
| 33 | Schlaufe |
| 34 | Amplitudenänderung |
| A | Lage der Störstelle |
| P | Prüfverfahren |
| U | Spannungssignal |
| S10-S13 | Verfahrensschritt |
| DC | Strom |

**Patentansprüche**

1. Prüfvorrichtung (10) zum Prüfen eines Datenkabels (11) für ein Kraftfahrzeug, aufweisend:

- eine Konstantstromquelle (13), die dazu eingerichtet ist, eine Stromstärke eines elektrischen Stroms (DC) auf einen vorbestimmten Sollwert (S) einzuregeln,
- eine Anschlusseinrichtung (17) zum Anschließen eines Endes (18) des Datenkabels (11),
- eine Schalteinrichtung (15), die dazu eingerichtet ist, die Konstantstromquelle (13) in Abhängigkeit von einem Schaltsignal (19) mit der Anschlusseinrichtung (17) elektrisch zu verbinden,
- einen Spannungsabgriff (21) zum Erfassen eines elektrischen Spannungssignals (U) des Datenkabels (11) und
- eine Steuereinrichtung (14), die dazu eingerichtet ist,
mittels des Schaltsignals (19) die Schalteinrichtung (15) zu schalten und damit die Konstantstromquelle (13) mit der Anschlusseinrichtung (17) zu verbinden und anschließend, während der auf den Sollwert (S) eingeregelte Strom (DC) der Konstantstromquelle (13) über die Anschlusseinrichtung (17) in das Datenkabel (11) oder aus dem Datenkabel (11) fließt, an dem Spannungsabgriff (21) das Spannungssignal (U) zu erfassen und einen vorbestimmten Zeitabschnitt (28) des Spannungssignals (U) auf der Grundlage eines vorbestimmten Prüfkriteriums (24) zum Erkennen einer Störstelle (12) in dem Datenkabel (11) zu prüfen;
**dadurch gekennzeichnet, dass**
das Prüfkriterium (25) unabhängig von einer Verschaltung eines anderen Endes (18') des Datenkabels (11) ist, wobei das Prüfkriterium vorsieht, dass nur ein solcher Zeitabschnitt (28) des Spannungssignals (U) berücksichtigt wird, der sich ergibt, bevor eine Reflexion eines Signals am anderen Ende (18') des Datenkabels (11) wieder das erste, angeschlossene Ende (18) des Datenkabels (11) oder den Spannungsabgriff (21) erreicht.

2. Prüfvorrichtung (10) nach Anspruch 1, wobei das Prüfkriterium (25) vorsieht, das Vorhandensein der Störstelle (12) in dem Datenkabel (11) zu signalisieren, falls der Zeitabschnitt (28) des Spannungssignals (U) zumindest teilweise außerhalb eines vorbestimmten Toleranzbands (29) liegt.

3. Prüfvorrichtung (10) nach einem der vorhergehenden Ansprüche, wobei das Prüfkriterium (25) vorsieht, den Zeitabschnitt (28) des Spannungssignals (U) mit zumindest einem Schwellenwert (30, 31) zu vergleichen und bei Überschreiten oder Unterschreiten des jeweiligen Schwellenwerts (30, 31) das Vorhandensein der Störstelle (12) zu signalisieren.

4. Prüfvorrichtung (10) nach einem der vorhergehenden Ansprüche, wobei das Prüfkriterium (25) vorsieht, einen Zeitverlauf des Zeitabschnitts (28) zu ermitteln und eine Lage (A) der Störstelle (12) entlang des Datenkabels (11) mittels einer vorbestimmten Zuordnungsvorschrift, welche jedem Zeitpunkt des Zeitverlaufs einen jeweiligen Ort entlang des Datenkabels (11) zuordnet, zu ermitteln.

5. Prüfvorrichtung (10) nach einem der vorhergehenden Ansprüche, wobei das Prüfkriterium (25) vorsieht, einem Deltawert einer Amplitudenänderung (34), welche der Zeitabschnitt (28) des Spannungssignals (U) aufweist, einen Wert einer Abmessung (D) und/oder einer Beschaffenheit der Störstelle (12) zuzuordnen.

6. Prüfvorrichtung (10) nach einem der vorhergehenden Ansprüche, wobei bei der Konstantstromquelle (13) eine Zeitkonstante (T) zum Einregeln der Stromstärke größer ist als eine Schaltdauer der Schalteinrichtung (15) und als eine Dauer des Zeitabschnitts (28).

7. Prüfvorrichtung (10) nach einem der vorhergehenden Ansprüche, wobei ein ohmsches Widerstandselement (16) bereitgestellt ist und die Schalteinrichtung (15) dazu eingerichtet ist, die Konstantstromquelle (13) in Abhängigkeit von dem Schaltsignal (19) abwechselnd mit dem Widerstandselement (16) einerseits und der Anschlusseinrichtung (17) andererseits elektrisch zu verbinden, und wobei die Steuereinrichtung (14) dazu eingerichtet ist, mittels des Schaltsignals (19) die Konstantstromquelle (13) zunächst mit dem Widerstandselement (16) zu verbinden und damit den Strom (DC) der Konstantstromquelle (13) über das Widerstandselement (16) zu führen, zumindest solange bis die Stromstärke den Sollwert (S) aufweist, und dann mittels des Schaltsignals (19) die Schalteinrichtung (15) umzuschalten.

8. Prüfvorrichtung (10) nach einem der vorhergehenden Ansprüche, wobei die Anschlusseinrichtung (17) ein Koaxial-Koppelelement (20) zum Anschließen eines Datenkabels (11), das als Koaxialkabel ausgestaltet ist, aufweist.

9. Prüfvorrichtung (10) nach Anspruch 8, wobei das Koaxial-Koppelelement (20) dazu ausgestaltet ist, bei angeschlossenem Koaxialkabel einen Außenleiter des Koaxialkabels mit einem Bezugspotential (22) der Prüfvorrichtung (10) zu koppeln.

10. Prüfvorrichtung (10) nach einem der vorhergehenden Ansprüche, wobei die Anschlusseinrichtung (17) ein Twisted-Pair-Koppelelement (20) zum Anschließen eines Datenkabels (11), das als Twisted-Pair-Kabel ausgestaltet ist, und/oder ein Koppelelement zum Anschließen eines platinenbasierten Zweileitersystems aufweist.

11. Prüfvorrichtung (10) nach Anspruch 10, wobei das Twisted-Pair-Koppelelement (20) ein Balun (27) aufweist.

12. Prüfvorrichtung (10) nach einem der vorhergehenden Ansprüche, wobei die Steuereinrichtung (14) einen Signalgenerator (23) zum mehrfachen und/oder periodischen Schalten der Schalteinrichtung (15) aufweist, und das Prüfkriterium (25) eine vorbestimmte Mindestanzahl an erfolgreichen Prüfdurchläufen zum Erkennen der Störstelle (12) vorsieht, bevor die Störstelle (12) als erkannt signalisiert wird oder bevor ein Freigabesignal (26), das die Abwesenheit einer Störstelle signalisiert, erzeugt wird.

13. Prüfverfahren (P) zum Prüfen eines Datenkabels (11) für ein Kraftfahrzeug, wobei eine Konstantstromquelle (13) eine Stromstärke eines elektrischen Stroms (DC) auf einen vorbestimmten Sollwert (S) einregelt und eine Schalteinrichtung (15) die Konstantstromquelle (13) in Abhängigkeit von einem Schaltsignal (19) mit einer Anschlusseinrichtung (17), an welcher ein Ende (18) des Datenkabels (11) angeschlossen ist, elektrisch verbindet, wobei eine Steuereinrichtung (14) mittels des Schaltsignals (19) die Schalteinrichtung (15) schaltet und damit die Konstantstromquelle (13) mit der Anschlusseinrichtung (17) verbindet und anschließend, während der auf den Sollwert (S) eingeregelte Strom (DC) der Konstantstromquelle (13) über die Anschlusseinrichtung (17) in das Datenkabel (11) oder aus dem Datenkabel (11) fließt, an einem Spannungsabgriff (21) ein Spannungssignal (U) des Datenkabels (11) erfasst und einen vorbestimmten Zeitabschnitt (28) des Spannungssignals (U) auf der Grundlage eines vorbestimmten Prüfkriteriums (25) zum Erkennen einer Störstelle (12) in dem Datenkabel (11) prüft, **dadurch gekennzeichnet, dass**
das Prüfkriterium (25) unabhängig von einer Verschaltung eines anderen Endes (18') des Datenkabels (11) ist, wobei das Prüfkriterium vorsieht, dass nur ein solcher Zeitabschnitt (28) des Spannungssignals (U) berücksichtigt wird, der sich ergibt, bevor eine Reflexion eines Signals am anderen Ende (18') des Datenkabels (11) wieder das erste, angeschlossene Ende (18) des Datenkabels (11) oder den Spannungsabgriff (21) erreicht.

14. Prüfverfahren (P) nach Anspruch 13, wobei nur bei unerfülltem Prüfkriterium (25), wenn keine Störstelle (12) signalisiert wird, ein Freigabesignal (26) zum Freigeben des Datenkabels (11) für eine Montage und/oder einen Betrieb erzeugt wird.

## Claims

1. Test device (10) for testing a data cable (11) for a motor vehicle, having:

   - a constant current source (13) which is configured to adjust a current intensity of an electrical current (DC) to a predetermined target value (S),
   - a connection device (17) for connecting one end (18) of the data cable (11),
   - a switching device (15) which is configured to electrically connect the constant current source (13) to the connection device (17) on the basis of a switching signal (19),
   - a voltage tap (21) for capturing an electrical voltage signal (U) of the data cable (11), and
   - a control device (14) which is configured to switch the switching device (15) using the switching signal (19) and to therefore connect the constant current source (13) to the connection device (17) and then, while the current (DC) from the constant current source (13) which has been adjusted to the target value (S) is flowing into the data cable (11) or out of the data cable (11) via the connection device (17), to capture the voltage signal (U) at the voltage tap (21) and to test a predetermined period (28) of the voltage signal (U) on the basis of a predetermined test criterion (24) for detecting a defect (12) in the data cable (11);
   **characterized in that**
   the test criterion (25) is independent of a connection of another end (18') of the data cable (11), wherein the test criterion provides for only such a period (28) of the voltage signal (U) which arises before a reflection of a signal at the other end (18') of the data cable (11) reaches the first, connected end (18) of the data cable (11) or the voltage tap (21) again to be taken into account.

2. Test device (10) according to Claim 1, wherein the test criterion (25) provides for the presence of the defect (12) in the data cable (11) to be signalled if the period (28) of the voltage signal (U) is at least partially outside a predetermined tolerance band (29).

3. Test device (10) according to one of the preceding claims, wherein the test criterion (25) provides for the period (28) of the voltage signal (U) to be compared with at least one threshold value (30, 31) and for the presence of the defect (12) to be signalled if the respective threshold value (30, 31) is exceeded or undershot.

4. Test device (10) according to one of the preceding claims, wherein the test criterion (25) provides for a time profile of the period (28) to be determined and for a position (A) of the defect (12) along the data cable (11) to be determined by means of a predetermined assignment rule which assigns a respective location along the data cable (11) to each time in the time profile.

5. Test device (10) according to one of the preceding claims, wherein the test criterion (25) provides for a value of a dimension (D) and/or nature of the defect (12) to be assigned to a delta value of an amplitude change (34) featured in the period (28) of the voltage signal (U).

6. Test device (10) according to one of the preceding claims, wherein, in the case of the constant current source (13), a time constant (T) for adjusting the current intensity is greater than a switching duration of the switching device (15) and a duration of the period (28).

7. Test device (10) according to one of the preceding claims, wherein a non-reactive resistance element (16) is provided and the switching device (15) is configured to alternately electrically connect the constant current source (13) to the resistance element (16), on the one hand, and to the connection device (17), on the other hand, on the basis of the switching signal (19), and wherein the control device (14) is configured to initially connect the constant current source (13) to the resistance element (16) using the switching signal (19) and to therefore guide the current (DC) from the constant current source (13) via the resistance element (16), at least until the current intensity has the target value (S), and to then change over the switching device (15) using the switching signal (19).

8. Test device (10) according to one of the preceding claims, wherein the connection device (17) has a coaxial coupling element (20) for connecting a data cable (11) which is in the form of a coaxial cable.

9. Test device (10) according to Claim 8, wherein the coaxial coupling element (20) is configured, when the coaxial cable is connected, to couple an outer conductor of the coaxial cable to a reference potential (22) of the test device (10).

10. Test device (10) according to one of the preceding claims, wherein the connection device (17) has a twisted-pair coupling element (20) for connecting a data cable (11) which is in the form of a twisted-pair cable, and/or a coupling element for connecting a board-based two-conductor system.

11. Test device (10) according to Claim 10, wherein the twisted-pair coupling element (20) has a balun (27).

**12.** Test device (10) according to one of the preceding claims, wherein the control device (14) has a signal generator (23) for repeatedly and/or periodically switching the switching device (15), and the test criterion (25) provides for a predetermined minimum number of successful test runs for detecting the defect (12) before the defect (12) is signalled as detected or before a release signal (26) signalling the absence of a defect is generated.

**13.** Test method (P) for testing a data cable (11) for a motor vehicle, wherein a constant current source (13) adjusts a current intensity of an electrical current (DC) to a predetermined target value (S) and a switching device (15) electrically connects the constant current source (13) to a connection device (17), to which one end (18) of the data cable (11) is connected, on the basis of a switching signal (19), wherein a control device (14) switches the switching device (15) using the switching signal (19) and therefore connects the constant current source (13) to the connection device (17) and then, while the current (DC) from the constant current source (13) which has been adjusted to the target value (S) is flowing into the data cable (11) or out of the data cable (11) via the connection device (17), captures a voltage signal (U) of the data cable (11) at a voltage tap (21) and tests a predetermined period (28) of the voltage signal (U) on the basis of a predetermined test criterion (25) for detecting a defect (12) in the data cable (11), **characterized in that**
the test criterion (25) is independent of a connection of another end (18') of the data cable (11), wherein the test criterion provides for only such a period (28) of the voltage signal (U) which arises before a reflection of a signal at the other end (18') of the data cable (11) reaches the first, connected end (18) of the data cable (11) or the voltage tap (21) again to be taken into account.

**14.** Test method (P) according to Claim 13, wherein a release signal (26) for releasing the data cable (11) for installation and/or operation is generated only when the test criterion (25) is not satisfied if a defect (12) is not signalled.

**Revendications**

**1.** Dispositif de vérification (10) servant à vérifier un câble de données (11) pour un véhicule automobile, présentant :

- une source de courant constant (13) qui est conçue pour régler une intensité de courant d'un courant électrique (DC) sur une valeur de consigne prédéterminée (S),
- un dispositif de connexion (17) servant à connecter une extrémité (18) du câble de données (11),
- un dispositif de commutation (15) qui est conçu pour relier électriquement la source de courant constant (13) au dispositif de connexion (17) en fonction d'un signal de commutation (19),
- une prise de tension (21) servant à détecter un signal de tension électrique (U) du câble de données (11), et
- un dispositif de commande (14) qui est conçu pour commuter, au moyen du signal de commutation (19), le dispositif de commutation (15) et relier ainsi la source de courant constant (13) au dispositif de connexion (17), et ensuite, pendant que le courant (DC) de la source de courant constant (13), réglé sur la valeur de consigne (S), entre dans le câble de données (11) ou sort du câble de données (11) par le dispositif de connexion (17), pour détecter à la prise de tension (21) le signal de tension (U) et pour vérifier un laps de temps prédéterminé (28) du signal de tension (U) sur la base d'un critère de vérification prédéterminé (24) afin d'identifier un défaut (12) dans le câble de données (11) ;

**caractérisé en ce que** le critère de vérification (25) est indépendant d'un câblage d'une autre extrémité (18') du câble de données (11), le critère de vérification prévoyant que seul un laps de temps (28) du signal de tension (U) soit pris en compte qui résulte avant qu'une réflexion d'un signal à l'autre extrémité (18') du câble de données (11) n'atteigne à nouveau la première extrémité connectée (18) du câble de données (11) ou la prise de tension (21).

**2.** Dispositif de vérification (10) selon la revendication 1, dans lequel le critère de vérification (25) prévoit de signaliser la présence du défaut (12) dans le câble de données (11) si le laps de temps (28) du signal de tension (U) se situe au moins partiellement en dehors d'une certaine bande de tolérance (29) prédéterminée.

**3.** Dispositif de vérification (10) selon l'une quelconque des revendications précédentes, dans lequel le critère de vérification (25) prévoit de comparer le laps de temps (28) du signal de tension (U) avec au moins une valeur seuil (30, 31), et de signaler la présence du défaut (12) en cas de dépassement ou de soupassement de la valeur seuil respective (30, 31).

**4.** Dispositif de vérification (10) selon l'une quelconque des revendications précédentes, dans lequel le critère de vérification (25) prévoit d'établir une courbe de temps du laps de temps (28) et d'établir une position (A) du défaut (12) le long du câble de données (11) au moyen d'une consigne d'affectation prédéterminée qui affecte à chaque instant de la courbe de temps un endroit respectif le long du câble de données (11).

5. Dispositif de vérification (10) selon l'une quelconque des revendications précédentes, dans lequel le critère de vérification (25) prévoit d'affecter à une valeur delta d'une variation d'amplitude (34) que présente le laps de temps (28) du signal de tension (U) une valeur d'une dimension (D) et/ou d'une nature du défaut (12).

6. Dispositif de vérification (10) selon l'une quelconque des revendications précédentes, dans lequel pour la source de courant constant (13), une constante de temps (T) pour le réglage de l'intensité de courant est supérieure à une durée de commutation du dispositif de commutation (15) et à une durée du laps de temps (28).

7. Dispositif de vérification (10) selon l'une quelconque des revendications précédentes, dans lequel un élément résistif ohmique (16) est fourni, et le dispositif de commutation (15) est conçu pour relier électriquement la source de courant constant (13) en alternance à l'élément résistif (16) d'une part et au dispositif de connexion (17) d'autre part en fonction du signal de commutation (19), et le dispositif de commande (14) étant conçu pour relier, au moyen du signal de commutation (19), la source de courant constant (13) d'abord à l'élément résistif (16) et pour ainsi faire passer le courant (DC) de la source de courant constant (13) à travers l'élément résistif (16) au moins jusqu'à ce que l'intensité de courant présente la valeur de consigne (S), et pour commuter ensuite le dispositif de commutation (15) au moyen du signal de commutation (19).

8. Dispositif de vérification (10) selon l'une quelconque des revendications précédentes, dans lequel le dispositif de connexion (17) présente un élément de couplage coaxial (20) servant à connecter un câble de données (11) configuré sous forme de câble coaxial.

9. Dispositif de vérification (10) selon la revendication 8, dans lequel l'élément de couplage coaxial (20) est configuré pour coupler un fil extérieur du câble coaxial avec un potentiel de référence (22) du dispositif de vérification (10) lorsque le câble coaxial est connecté.

10. Dispositif de vérification (10) selon l'une quelconque des revendications précédentes, dans lequel le dispositif de connexion (17) est un élément de couplage à paire torsadée (20) servant à connecter un câble de données (11) qui est configuré sous la forme d'un câble à paire torsadée, et/ou présente un élément de couplage servant à connecter un système à deux conducteurs à base d'une platine.

11. Dispositif de vérification (10) selon la revendication 10, dans lequel l'élément de couplage à paire torsadée (20) présente un symétriseur (27).

12. Dispositif de vérification (10) selon l'une quelconque des revendications précédentes, dans lequel le dispositif de commande (14) présente un générateur de signal (23) servant à la commutation multiple et/ou périodique du dispositif de commutation (15), et le critère de vérification (25) prévoit un nombre minimal prédéterminé de passages de vérification réussis pour identifier le défaut (12) avant que le défaut (12) ne soit signalé comme étant identifié ou avant qu'un signal de validation (26) signalant l'absence de défaut ne soit généré.

13. Procédé de vérification (P) permettant de vérifier un câble de données (11) pour un véhicule automobile, dans lequel une source de courant constant (13) règle une intensité de courant d'un courant électrique (DC) sur une valeur de consigne prédéterminée (S), et un dispositif de commutation (15) relie électriquement la source de courant constant (13) en fonction d'un signal de commutation (19) à un dispositif de connexion (17) auquel est connectée une extrémité (18) du câble de données (11), dans lequel un dispositif de commande (14) commute au moyen du signal de commutation (19) le dispositif de commutation (15) et reliant ainsi la source de courant constant (13) au dispositif de connexion (17), et ensuite, pendant que le courant (DC) de la source de courant constant (13), réglé sur la valeur de consigne (S), entre dans le câble de données (11) ou sort du câble de données (11) par le dispositif de connexion (17), détecte au niveau d'une prise de tension (21) un signal de tension (U) du câble de données (11) et vérifie un laps de temps prédéterminé (28) du signal de tension (U) sur la base d'un critère de vérification prédéterminé (25) servant à identifier un défaut (12) dans le câble de données (11),
**caractérisé en ce que** le critère de vérification (25) est indépendant d'un câblage d'une autre extrémité (18') du câble de données (11), le critère de vérification prévoyant que seul un laps de temps (28) du signal de tension (U) soit pris en compte qui résulte avant qu'une réflexion d'un signal à l'autre extrémité (18') du câble de données (11) n'atteigne à nouveau la première extrémité connectée (18) du câble de données (11) ou la prise de tension (21).

14. Procédé de vérification (P) selon la revendication 13, dans lequel un signal de libération (26) servant à valider le câble de données (11) pour un montage et/ou un fonctionnement n'est généré que si le critère de vérification (25) n'est pas rempli quand aucun défaut (12) n'est signalisé.

Fig.1

Fig.2

P

S10

S11

S12

S13

Fig.3

Fig.4

EP 3 462 195 B1

Fig.5

EP 3 462 195 B1

Fig.6

Fig.7

Fig.8

Fig.9

EP 3 462 195 B1

**EP 3 462 195 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102017108954
- DE 102017108955
- EP 2664932 A1
- US 20020130668 A1
- US 20040230387 A1